(19) Europäisches Patentamt
European Patent Office
Office européen des brevets

(11) **EP 3 645 981 B1**

(12) **FASCICULE DE BREVET EUROPEEN**

(45) Date de publication et mention de la délivrance du brevet:
**04.08.2021 Bulletin 2021/31**

(21) Numéro de dépôt: **18731495.0**

(22) Date de dépôt: **22.06.2018**

(51) Int Cl.:
*G01F 1/66* (2006.01)     *G01P 5/24* (2006.01)

(86) Numéro de dépôt international:
**PCT/EP2018/066810**

(87) Numéro de publication internationale:
**WO 2019/002145 (03.01.2019 Gazette 2019/01)**

(54) **PROCÉDÉ DE MESURE D'UNE VITESSE D'UN FLUIDE**

VERFAHREN ZUR MESSUNG EINER GESCHWINDIGKEIT EINES FLUIDS

METHOD FOR MEASURING A SPEED OF A FLUID

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.06.2017 FR 1755910**

(43) Date de publication de la demande:
**06.05.2020 Bulletin 2020/19**

(73) Titulaire: **Sagemcom Energy & Telecom SAS
92500 Rueil-Malmaison (FR)**

(72) Inventeur: **TEBOULLE, Henri
92500 Rueil Malmaison (FR)**

(74) Mandataire: **Lavaud, Thomas et al
Cabinet Boettcher
16, rue Médéric
75017 Paris (FR)**

(56) Documents cités:
| | |
|---|---|
| **EP-A2- 0 797 105** | **WO-A1-2016/150385** |
| **US-A1- 2005 055 171** | **US-A1- 2016 334 255** |

Printed by Jouve, 75001 PARIS (FR)

**Description**

L'invention concerne le domaine des procédés de mesure d'une vitesse d'un fluide.

ARRIERE PLAN DE L'INVENTION

Un compteur de fluide à ultrason utilise classiquement, pour mesurer un débit d'un fluide circulant dans un tuyau, un dispositif de mesure de la vitesse du fluide par émission et réception de signaux ultrasonores de mesure.

Le dispositif de mesure comporte un conduit, raccordé au tuyau, dans lequel circule le fluide. Pour mesurer la vitesse du fluide, on émet dans le conduit un signal ultrasonore de mesure parcourant un trajet de longueur définie, on mesure les temps de trajet mis par le signal ultrasonore de mesure pour parcourir le trajet de longueur définie d'amont en aval et d'aval en amont, et on estime la vitesse du fluide à partir notamment de la longueur définie et de la différence entre les temps de trajet.

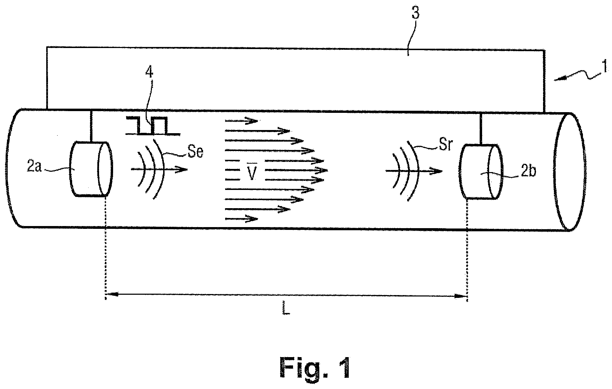

Un tel dispositif de mesure 1, parfois désigné par les termes anglais *classical pipe,* est visible sur la figure 1. Le dispositif de mesure 1 comporte un premier transducteur 2a, un deuxième transducteur 2b, et un module de mesure 3 relié au premier transducteur 2a et au deuxième transducteur 2b.

Le premier transducteur 2a et le deuxième transducteur 2b sont appairés en fréquence et en niveau d'émission. Le premier transducteur 2a et le deuxième transducteur 2b sont par exemple des transducteurs piézoélectriques.

Le trajet de longueur définie est donc un trajet rectiligne de longueur L entre le premier transducteur 2a et le deuxième transducteur 2b.

Le premier transducteur 2a émet un signal ultrasonore de mesure Se. Le signal ultrasonore de mesure Se est par exemple généré à partir d'un signal rectangulaire 4. Le deuxième transducteur 2b reçoit un signal ultrasonore de mesure reçu Sr résultant de la propagation dans le fluide du signal ultrasonore de mesure Se.

Le module de mesure 3 mesure le temps de trajet mis par le signal ultrasonore de mesure Se pour parcourir le trajet de longueur définie d'amont en aval.

Le module de mesure 3 mesure en réalité un temps de transfert global $T_{AB}$ du premier transducteur 2a vers le deuxième transducteur 2b.

Le temps de transfert global $T_{AB}$ est tel que :

$$T_{AB} = TA_A + ToF_{AB} + TR_B,$$

où :

- $TA_A$ est un temps d'allumage du premier transducteur 2a ;

- $ToF_{AB}$ correspond au *Time of Flight* (« Temps de Vol », en français) mis par le signal ultrasonore de mesure Se pour parcourir le trajet de longueur définie entre le premier transducteur 2a et le deuxième transducteur 2b ;
- $TR_B$ est un temps de réception du deuxième transducteur 2b.

De même, le deuxième transducteur 2b émet un signal ultrasonore de mesure qui est reçu par le premier transducteur 2a.

Le temps de transfert global $T_{BA}$ est tel que :

$$T_{BA} = TA_B + ToF_{BA} + TR_A,$$

où :

- $TA_B$ est un temps d'allumage du deuxième transducteur 2b ;
- $ToF_{BA}$ correspond au *Time of Flight* mis par le signal ultrasonore de mesure pour parcourir le trajet de longueur définie entre le deuxième transducteur 2b et le premier transducteur 2a ;
- $TR_A$ est un temps de réception du premier transducteur 2a.

En supposant que :
$TA_A = TA_B$ et $TR_A = TR_B$, on obtient :

$$\Delta T = T_{BA} - T_{AB} = ToF_{BA} - ToF_{AB} = DToF,$$

où DToF est le *Differential Time of Flight.*

Or, le DToF est proportionnel à la vitesse moyenne $\overline{V}$ du fluide, et le module de mesure 3 calcule alors la vitesse moyenne $\overline{V}$ du fluide en utilisant la formule : $DToF = 2L.\overline{V}(C^2 - \overline{V}^2)$, où C est la vitesse d'une onde ultrasonore dans le fluide. Par exemple, la vitesse d'une onde ultrasonore dans l'eau est égale à environ 1500m/s, et dépend de la température de l'eau.

Le module de mesure 3 déduit alors de la vitesse moyenne $\overline{V}$, signée, le débit du fluide circulant dans le tuyau.

La plage de mesure de débit spécifiée pour un tel compteur de fluide à ultrason est très large, et peut s'étendre entre un débit de démarrage de mesure de 11/h et un débit maximal de 25001/h. Une telle plage de mesure de débit correspond à des DToF signés dont la valeur absolue est comprise dans une plage de mesure temporelle qui s'étend, à la température de l'eau de 20°C, entre 315ps et 393,5ns. Il convient, pour obtenir la précision requise dans l'ensemble de la plage de mesure de débit, de produire des mesures de DToF particulièrement précises sur l'ensemble de la plage de mesure temporelle.

La demande US 2016/334255 A1 décrit un système de mesure de débit de fluide, qui comprend un premier transducteur à ultrasons configuré pour émettre une ou plusieurs versions d'un signal d'émission TX à travers le fluide, et un deuxième transducteur à ultrasons configuré pour recevoir un ou plusieurs signaux de réception RX respectifs.

Le système de mesure de débit de fluide comprend un convertisseur analogique-numérique configuré pour échantillonner, à une première fréquence, les un ou plusieurs signaux ultrasonores RX et un processeur configuré pour générer un signal de résolution fine sur la base des un ou plusieurs signaux ultrasonores RX. Le signal de résolution fine est associé à une fréquence d'échantillonnage supérieure à la première fréquence d'échantillonnage. Le processeur est également configuré pour calculer un signal de corrélation croisée indicatif d'une corrélation croisée entre le signal de résolution fine et une forme d'onde et déterminer un paramètre de débit de fluide estimé sur la base du signal de corrélation croisée calculée.

OBJET DE L'INVENTION

L'invention a pour objet d'améliorer la précision de mesures de débit réalisées par un compteur de fluide à ultrason.

RESUME DE L'INVENTION

En vue de la réalisation de ce but, on propose un procédé de mesure d'une vitesse d'un fluide, comprenant les étapes de :

- émettre un signal ultrasonore de mesure ;
- acquérir et numériser une portion de mesure d'un signal ultrasonore de mesure reçu après que le signal ultrasonore de mesure ait parcouru un trajet de longueur définie, pour obtenir des échantillons de mesure ;
- estimer, à partir des échantillons de mesure, une amplitude de la portion de mesure ;
- accéder à des échantillons de référence d'une table de référence préremplie et stockée dans une mémoire, les échantillons de référence formant une courbe de référence qui constitue une interpolation des échantillons de mesure ;
- produire des échantillons de mesure ajustés en multipliant les échantillons de mesure par un rapport entre une amplitude de la courbe de référence et l'amplitude de la portion de mesure ;
- pour chaque échantillon de mesure ajusté, déterminer un décalage temporel unitaire entre l'échantillon de mesure ajusté et la courbe de référence ;
- pour chaque échantillon de mesure ajusté, estimer un instant de passage par zéro de la portion de mesure à partir du décalage temporel unitaire et des échantillons de référence ;
- estimer, à partir d'une moyenne des instants de passage par zéro, une mesure de temps de trajet du signal ultrasonore de mesure pour parcourir le trajet de longueur définie ;
- estimer la vitesse du fluide à partir de la mesure de temps de trajet.

La numérisation de la portion de mesure du signal ultrasonore de mesure reçu permet d'obtenir des échantillons de mesure sur lesquels il est possible de réaliser divers traitements. Ces traitements fournissent une estimation très précise de la vitesse du fluide et donc du débit.

On propose aussi un compteur de fluide à ultrason comportant un premier transducteur, un deuxième transducteur, et un module de mesure comportant un microcontrôleur maître, un microcontrôleur esclave et un FPGA dans lequel est programmé un bloc de génération de retard, le compteur de fluide à ultrason étant agencé pour mettre en œuvre le procédé de mesure qui vient d'être décrit.

On propose aussi un programme d'ordinateur comprenant des instructions pour mettre en œuvre, par un microcontrôleur d'un compteur de fluide à ultrason, le procédé de mesure qui vient d'être décrit.

On propose de plus des moyens de stockage qui stockent un programme d'ordinateur comprenant des instructions pour mettre en œuvre, par un microcontrôleur d'un compteur de fluide à ultrason, le procédé de mesure qui vient d'être décrit.

D'autres caractéristiques et avantages de l'invention ressortiront à la lecture de la description qui suit de modes de réalisation particuliers non limitatifs de l'invention.

BREVE DESCRIPTION DES DESSINS

Il sera fait référence aux dessins annexés, parmi lesquels :

- la figure 1 représente un compteur de fluide à ultrason selon l'art antérieur ;
- la figure 2 représente un compteur de fluide à ultrason dans lequel est mis en œuvre un procédé de mesure selon un premier mode de réalisation de l'invention ;
- la figure 3 représente un microcontrôleur maître, un microcontrôleur esclave et un FPGA d'un module de mesure du compteur de fluide à ultrason ;
- la figure 4 représente un signal ultrasonore de mesure reçu après avoir parcouru un trajet de longueur définie d'amont en aval, et un signal ultrasonore de mesure reçu après avoir parcouru un trajet de longueur définie d'aval en amont ;
- la figure 5 représente des courbes de référence ;
- la figure 6 est un graphique sur lequel sont représentés des points de mesure de temps de trajet.

DESCRIPTION DETAILLEE DE L'INVENTION

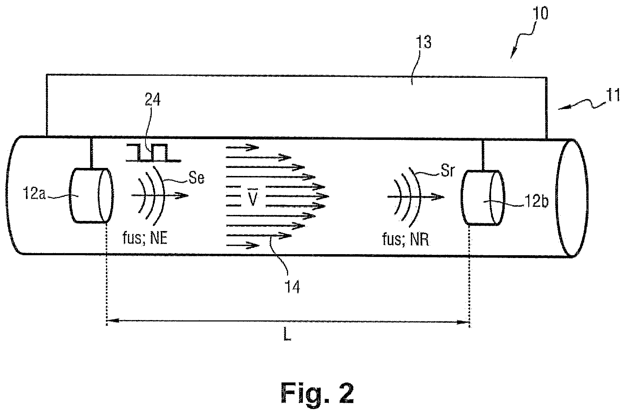

En référence à la figure 2, le procédé de mesure d'une vitesse d'un fluide selon un premier mode de réalisation de l'invention est ici mis en œuvre dans un compteur d'eau à ultrason 10.

Le compteur d'eau à ultrason 10 comporte un conduit dans lequel circule de l'eau fournie par un réseau de distribution à une installation, ainsi qu'un dispositif de mesure de la vitesse de l'eau 11.

L'eau circule dans le conduit d'amont en aval, comme cela est indiqué par le sens des flèches 14, mais pourrait tout aussi bien circuler d'aval en amont.

Le dispositif de mesure 11 comporte un premier transducteur 12a, un deuxième transducteur 12b, et un module de mesure 13 relié au premier transducteur 12a et au deuxième transducteur 12b.

Le premier transducteur 12a et le deuxième transducteur 12b sont appairés. Le premier transducteur 12a et le deuxième transducteur 12b sont ici des transducteurs piézoélectriques.

Le module de mesure 13 pilote le premier transducteur 12a et le deuxième transducteur 12b.

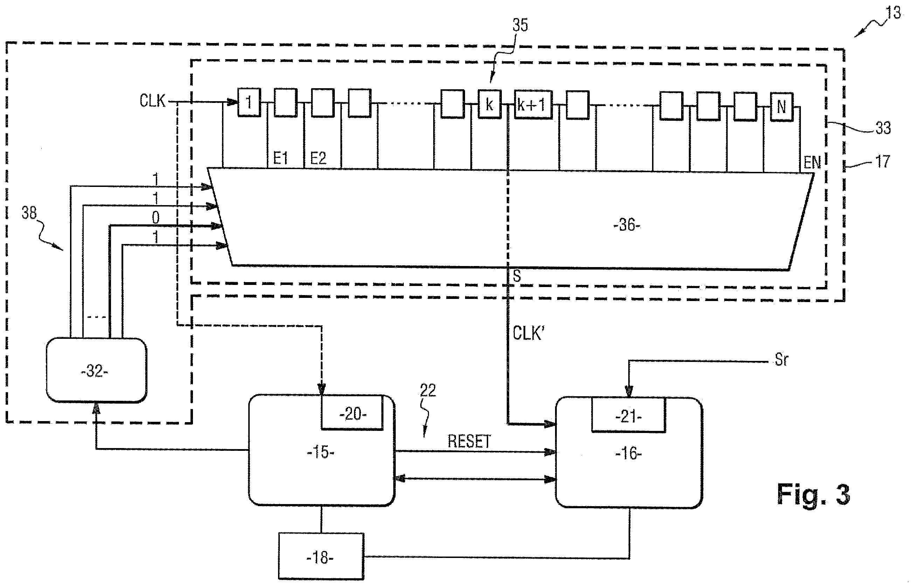

En référence à la figure 3, le module de mesure 13 comporte un microcontrôleur maître 15, un microcontrôleur esclave 16, un FPGA 17 et une mémoire 18.

Le microcontrôleur maître 15 comporte un bloc de mesure de température 20, qui acquiert des mesures de température du fluide réalisées par un capteur de température situé dans le conduit ou à proximité du conduit.

Le microcontrôleur esclave 16 comprend un convertisseur analogique numérique 12 bits 21.

Le microcontrôleur maître 15 et le microcontrôleur esclave 16 sont reliés par un canal de communication 22 qui est ici un bus SPI (pour *Serial Peripheral Interface*).

Le microcontrôleur maître 15 est relié au FPGA 17.

Le premier transducteur 12a et le deuxième transducteur 12b remplissent chacun successivement la fonction d'un émetteur de signaux ultrasonores de mesure Se, et la fonction d'un récepteur de signaux ultrasonores de mesure reçus Sr.

Le module de mesure 13 fournit ainsi à l'émetteur des signaux électriques que celui-ci transforme en signaux ultrasonores de mesure Se. Les signaux électriques sont ici des signaux rectangulaires 24. Le module de mesure 13 acquiert les signaux ultrasonores de mesure reçus Sr qui sont reçus par le récepteur.

L'émetteur émet les signaux ultrasonores de mesure Se à une fréquence d'émission fus. La fréquence fus est classiquement comprise entre 900kHz et 4MHz, et est ici égale à 1MHz.

Les signaux ultrasonores de mesure Se parcourent ainsi, entre le premier transducteur 12a et le deuxième transducteur 12b, un trajet de longueur définie L d'amont en aval et d'aval en amont. Le trajet de longueur définie est ici un trajet rectiligne entre le premier transducteur 12a et le deuxième transducteur 12b.

Sur la figure 2, on a représenté le premier transducteur 12a remplissant la fonction d'un émetteur et le deuxième transducteur 12b remplissant la fonction d'un récepteur. Le signal ultrasonore de mesure Se parcourt donc le trajet de longueur définie d'amont en aval. Le signal ultrasonore de mesure Se est émis par l'émetteur avec un niveau NE. Le signal ultrasonore de mesure reçu Sr est reçu par le récepteur avec un niveau NR inférieur au niveau NE.

Le module de mesure 13 produit une mesure de temps de trajet représentative d'un temps mis par le signal ultrasonore de mesure Se pour parcourir le trajet de longueur définie L d'amont en aval, puis produit une mesure de temps de trajet représentative d'un temps mis par le signal ultrasonore de mesure Se pour parcourir le trajet de longueur définie L d'aval en amont, puis enfin évalue la vitesse de l'eau en fonction de ces mesures de temps de trajet.

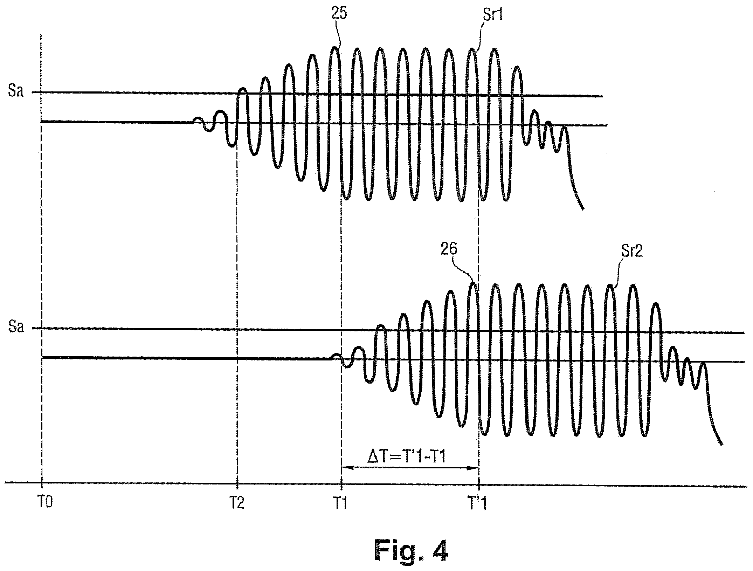

La figure 4 représente tout d'abord un signal ultrasonore de mesure reçu Sr1 qui est reçu par le module de mesure 13 après avoir parcouru le trajet de longueur définie L d'amont en aval.

Le récepteur active la réception à un moment T0, synchronisé avec l'émission du signal ultrasonore de mesure. L'appairage de l'émetteur et du récepteur rend possible cette synchronisation.

La mesure de temps de trajet d'amont en aval est obtenue à partir de la détermination d'un moment de survenue T1 d'un lobe prédéterminé du signal ultrasonore de mesure reçu Sr1.

Le moment de survenue T1 est ici l'instant où survient un front descendant du lobe prédéterminé. Le moment de survenue T1 est un instant de passage par zéro qui est mesuré par une méthode du type « *Zero Crossing* ».

Le lobe prédéterminé est un $j^{ième}$ lobe du signal ultrasonore de mesure reçu Sr1 après qu'une amplitude du signal ultrasonore de mesure reçu Sr1 ait dépassé, au temps T2, un seuil d'amplitude prédéterminé Sa. Le $j^{ième}$ lobe est en l'occurrence ici le quatrième lobe 25.

La figure 4 représente de plus un signal ultrasonore de mesure reçu Sr2 qui est reçu par le module de mesure 13 après avoir parcouru le trajet de longueur définie L d'aval en amont.

La mesure de temps de trajet d'aval en amont est obtenue à partir de la détermination d'un moment de survenue T'1 du quatrième lobe 26 du signal ultrasonore de mesure reçu Sr2.

La vitesse de l'eau est ensuite évaluée par le module de mesure 13 en fonction de la mesure de temps de trajet d'amont en aval et de la mesure de temps de trajet d'aval en amont.

La vitesse de l'eau est proportionnelle à une différence entre la mesure de temps de trajet d'aval en amont et la mesure de temps de trajet d'amont en aval.

On note que la vitesse de l'eau mesurée est une vitesse moyenne de l'eau dans le diamètre du conduit, la vitesse des masses d'eau étant en effet différente au centre du conduit et à proximité des parois du conduit.

L'un des buts du procédé de mesure est d'obtenir une mesure très précise des moments de survenue T1 et T'1.

Chaque signal ultrasonore de mesure reçu Sr est acquis par le microcontrôleur esclave 16 du module de mesure 13.

Le convertisseur analogique numérique 21 du microcontrôleur esclave 16 numérise une portion de mesure du signal ultrasonore de mesure reçu Sr.

La portion de mesure correspond au quatrième lobe défini plus haut. Le module de mesure 13 maîtrise le moment d'émission du signal ultrasonore de mesure Se et peut donc estimer un intervalle de temps au cours duquel est acquis le quatrième lobe.

Le convertisseur analogique numérique 21 échantillonne à 4MHz le signal ultrasonore de mesure reçu Sr.

Le microcontrôleur esclave 16 produit ici quatre échantillons de mesure espacés chacun de la période d'échantillonnage $T_e$ = 250ns. Les quatre échantillons de mesure sont donc situés sur le quatrième lobe.

Puis, le microcontrôleur esclave 16 estime un offset des quatre échantillons de mesure en calculant une moyenne des quatre échantillons de mesure. L'*offset* est soustrait à chaque échantillon de mesure. En variante, l'offset peut être déterminé sur la moyenne arithmétique de tous les échantillons sur la mesure précédente.

Le microcontrôleur esclave 16 estime alors une amplitude de la portion de mesure, c'est à dire du quatrième lobe, à partir des échantillons de mesure.

Chaque échantillon de mesure $A_k$ (k varie ici entre 1 et 4) peut être estimé par la formule : $A_k = a_{mes} \cdot \sin(2\pi \cdot f_{us} \cdot n \cdot T_e + \varphi) = a_{mes} \cdot \sin(n \cdot \pi/2 + \varphi)$, où la phase $\varphi$ est fixe pour les échantillons de mesure $A_k$.

L'estimation de l'amplitude du quatrième lobe consiste donc à calculer la valeur $a_{mes}$.

Le microcontrôleur esclave 16 va ensuite accéder à des échantillons de référence contenus dans une table de référence préremplie et stockée dans la mémoire 18. Les échantillons de référence forment une courbe de référence.

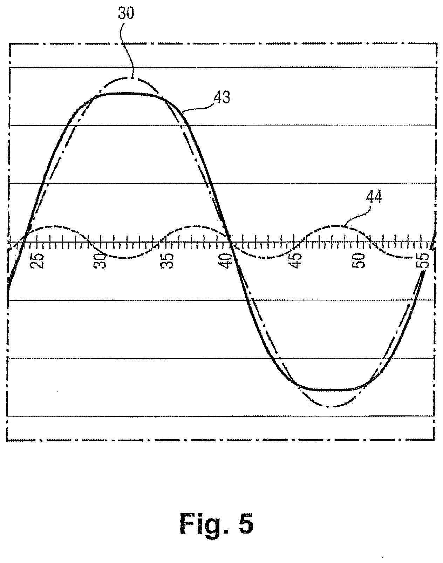

En référence à la figure 5, la courbe de référence est ici une période d'une sinusoïde de référence 30 de fréquence 1MHz, ce qui correspond à la fréquence $f_{us}$ du signal ultrasonore de mesure Se et donc du signal ultrasonore de mesure reçu Sr. Deux échantillons de référence sont ici espacés temporellement de 50ps, de sorte que 20000 échantillons de référence sont stockés dans la mémoire 18.

Le microcontrôleur esclave 16 calcule un rapport entre l'amplitude de la sinusoïde de référence 30 et l'amplitude du quatrième lobe, et ajuste les échantillons de mesure $A_k$ en les multipliant par ledit rapport.

Le microcontrôleur esclave 16 produit donc des échantillons de mesure ajustés.

La sinusoïde de référence 30 constitue une interpolation sinusoïdale des échantillons de mesure ajustés et donc des échantillons de mesure, si ce n'est qu'un décalage temporel unitaire existe entre chaque échantillon de mesure ajusté et la sinusoïde de référence 30. Dans le cas où la sinusoïde de référence 30 a une phase nulle, le décalage temporel unitaire correspond à la phase de chaque échantillon de mesure ajusté, c'est à dire à la phase $\varphi$ évoquée plus tôt.

Le décalage temporel unitaire est différent selon les échantillons de mesure ajustés et dépend notamment d'un *jitter* dans le cadencement de l'échantillonnage.

Pour chaque échantillon de mesure ajusté, le décalage temporel unitaire est estimé de la manière suivante.

La valeur de l'échantillon de mesure ajusté est située nécessairement entre les valeurs de deux échantillons de référence. Le microcontrôleur esclave 16 réalise donc une interpolation linéaire ou une interpolation quadratique d'un ordre n quelconque, pour obtenir un temps de référence, sur la sinusoïde de référence, auquel est associée la valeur de l'échantillon de mesure ajusté. Le décalage temporel unitaire correspond à la différence entre le temps de référence et le temps de mesure auquel a été acquis l'échantillon de mesure dont résulte l'échantillon de mesure ajusté.

Puis, pour chaque échantillon de mesure ajusté, un instant de passage par zéro du quatrième lobe est estimé. Cette estimation utilise le décalage temporel unitaire et les échantillons de référence de la sinusoïde de référence 30. Le décalage temporel unitaire permet de caler la sinusoïde de référence 30 sur l'échantillon de mesure ajusté. Le microcontrôleur esclave 16 utilise donc les échantillons de référence décalés d'un retard égal au décalage temporel unitaire pour déterminer l'instant de passage par zéro. La détermination de l'instant de passage par zéro utilise donc des échantillons de référence « idéaux » n'ayant pas subi de perturbations de type *jitter.*

On obtient donc ici quatre estimations de l'instant de passage par zéro du quatrième lobe (une estimation pour chaque échantillon de mesure ajusté).

Une estimation finale de l'instant de passage par zéro est obtenue en moyennant les quatre instants de passage par zéro.

Le module de mesure 13 calcule ensuite une moyenne des décalages temporels unitaires pour obtenir un décalage temporel global, correspondant à un décalage entre la portion de mesure et la sinusoïde de référence 30.

Le procédé de mesure consiste ensuite à décaler, pour les acquisitions suivantes, l'échantillonnage de la portion de mesure du signal ultrasonore de mesure reçu Sr d'un retard d'échantillonnage égal au décalage temporel global. Ainsi, pour les acquisitions qui suivent, les échantillons de mesure ajustés coïnciderons avec des échantillons de référence « idéaux » de la sinusoïde de référence 30.

Le décalage de l'échantillonnage consiste à décaler le signal d'horloge CLK qui cadence le convertisseur analogique numérique 21 du microcontrôleur esclave 16.

Un bloc de commande 32 et un bloc de génération de retard 33 sont programmés à cet effet dans le FPGA 17. Le bloc de génération de retard 33 comporte une chaîne 35 de N étages de retard et un multiplexeur 36.

Chaque étage de retard comprend deux inverseurs montés en série. On désigne chacun des N étages de retard par sa position de gauche à droite dans la chaîne. La sortie de chaque k$^{ième}$ étage de retard est reliée à l'entrée du k+1$^{ième}$ étage de retard.

Le FPGA 17 reçoit le signal d'horloge CLK. Le signal d'horloge CLK est appliqué en entrée du premier étage de retard, c'est à dire en entrée de la chaîne 35 des N étages de retard.

Le multiplexeur 36 comporte N entrées E1...EN reliées chacune à la sortie de l'un des étages de retard, et une sortie S. Le multiplexeur 36 reçoit par ailleurs N signaux de commande 38. Chaque signal de commande 38 est associé à un étage de retard. Tous les signaux de commande sont à 1, sauf l'un des signaux de commande 38 qui est à 0. La sortie de l'étage de retard associé au signal de commande 38 qui est à 0 est appliquée sur la sortie S du multiplexeur 36. La sortie S du multiplexeur 36 est reliée au microcontrôleur esclave 16.

La sortie de chaque étage de retard est associée à un retard déterminé différent appliqué au signal d'horloge CLK. Les retards déterminés ont été calibrés en usine et sont mémorisés par le microcontrôleur maître 15.

Le microcontrôleur esclave 16 acquiert donc la portion de mesure du signal ultrasonore reçu Sr, qui est numérisée par le convertisseur analogique numérique 21.

Le microcontrôleur esclave 16 définit le décalage temporel global, et transmet au microcontrôleur maître 15 la valeur du décalage temporel global via le canal de communication 22.

Le microcontrôleur maître 15 applique alors sur le signal d'horloge CLK un retard d'échantillonnage égal au décalage temporel global en programmant le bloc de commande 32 qui produit les signaux de commande 38. Les signaux de commande 38 pilotent le multiplexeur 36 pour que la sortie de l'étage de retard appliquée sur la sortie S du multiplexeur 36 soit associée à un retard déterminé égal au décalage temporel global.

Le microcontrôleur maître 15 réinitialise alors le microcontrôleur esclave 16, grâce à un signal RESET. Le microcontrôleur esclave 16 utilise alors, pour l'échantillonnage suivant, un signal d'horloge décalé CLK'. Le signal d'horloge décalé CLK' correspond au signal d'horloge CLK retardé d'un retard d'échantillonnage égal au décalage temporel global.

Le microcontrôleur esclave 16 détermine alors directement, pour chaque échantillon de mesure ajusté, un instant de passage par zéro à partir des échantillons de référence. Une estimation finale de l'instant de passage par zéro est obtenue en moyennant les quatre instants de passage par zéro.

Un décalage opposé au décalage temporel global est ensuite ajouté à l'estimation finale de l'instant de passage par zéro pour compenser le retard d'échantillonnage.

Le temps de trajet est ensuite estimé à partir de l'instant de passage par zéro.

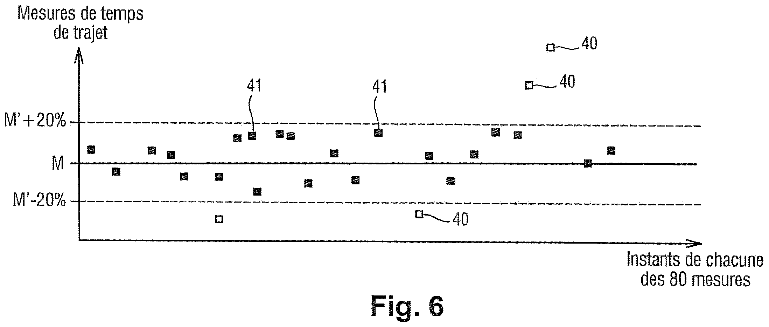

Puis, en référence à la figure 6, le microcontrôleur esclave 16 améliore encore la précision des mesures de temps de trajet. L'amélioration de la précision des mesures de temps de trajet consiste tout d'abord à calculer une moyenne M' d'un nombre n de mesures de temps de trajet. Le nombre n est ici égal à 80.

On détermine ensuite des mesures de temps de trajet imprécises 40 situées à l'extérieur d'une plage [M'-X ; M'+X]. X est un pourcentage prédéterminé de la moyenne M'. X est avantageusement compris entre 3% et 30% de M'. X est ici égal à 20% de M'.

On élimine ensuite les mesures de temps de trajet imprécises 40 et on calcule M, qui est la moyenne des mesures de temps de trajet 41 à l'intérieur de la plage [M'-20% ; M'+20%].

On améliore ainsi encore de manière importante la précision de la mesure de temps de trajet. La précision finale obtenue est classiquement comprise entre 10ps et 20ps.

Bien sûr, les opérations qui viennent d'être décrites sont réalisées pour le trajet d'aval en amont et d'amont en aval.

La vitesse du fluide est alors obtenue à partir de la différence entre le temps de trajet d'amont en aval et le temps de trajet d'aval en amont.

L'utilisation de la sinusoïde de référence 30 et des échantillons de référence permet de s'affranchir d'éventuelles distorsions de temps de trajet qui fausseraient les mesures. On améliore ainsi les performances métrologiques.

On note d'ailleurs que la courbe de référence ne comporte pas nécessairement une période de sinusoïde : un quart de période serait suffisant.

La courbe de référence peut par ailleurs présenter une forme autre que sinusoïdale. En référence à nouveau à la figure 5, la mémoire 18 peut par exemple contenir des échantillons de référence de courbes pseudo-sinusoïdales telles que la courbe pseudo-sinusoïdale 43. Chaque courbe pseudo-sinusoïdale 43 est échantillonnée à 50ps.

Chaque courbe pseudo-sinusoïdale 43 est obtenue en additionnant à la sinusoïde 30 une ou des courbes additionnelles 44. Une courbe additionnelle 44 est en l'occurrence une courbe de l'harmonique de rang 3 de la fréquence 1MHz (c'est à dire de la fréquence du signal ultrasonore de mesure).

Le choix de la courbe de référence peut alors dépendre de la température du fluide. Le microcontrôleur maître 15 acquiert, via le bloc de mesure de température 20, la température du fluide. Le microcontrôleur maître 15 sélectionne alors dans la mémoire 18 la courbe de référence dont le profil correspond au profil de la portion de mesure du signal ultrasonore de mesure reçu à ladite température du fluide.

On note ici qu'il est possible, pour améliorer la précision du procédé de mesure, de réaliser l'ensemble des opérations décrites non seulement sur le quatrième lobe mais aussi sur un ou plusieurs autres lobes. On réalise ainsi par exemple un échantillonnage du cinquième lobe et du sixième lobe, on détermine les instants de passage par zéro du cinquième lobe et du sixième lobe, et on affine grâce aux différents instants de passage par zéro les mesures de temps de trajet.

Le procédé de mesure d'une vitesse d'un fluide selon un deuxième mode de réalisation utilise cette fois un unique microcontrôleur. Le procédé de mesure est alors purement numérique, et ne consiste pas à appliquer un retard d'échantillonnage au signal d'horloge du convertisseur analogique numérique.

Dans le deuxième mode de réalisation, à chaque acquisition d'un signal ultrasonore de mesure reçu, le microcontrôleur du module de mesure évalue à nouveau un décalage temporel unitaire entre chaque échantillon de mesure ajusté et la courbe de référence. L'évaluation du décalage temporel unitaire est faite par interpolation linéaire ou par interpolation quadratique ordre n.

Pour chaque échantillon de mesure ajusté, le microcontrôleur « cale » alors la courbe de référence sur l'échantillon de mesure ajusté, estime l'instant de passage par zéro, et décale l'instant de passage par zéro du décalage temporel unitaire. Une estimation finale de l'instant de passage par zéro est obtenue en moyennant les quatre instants de passage par zéro. La vitesse du fluide est générée à partir de l'estimation finale de l'instant de passage par zéro, et ces opérations sont reproduites pour chaque signal ultrasonore de mesure reçu.

Le procédé de mesure selon le deuxième mode de réalisation nécessite des composants matériels (*hardware*) moins nombreux que le procédé de mesure selon le premier mode de réalisation. Le procédé de mesure selon le deuxième mode de réalisation requiert cependant de réaliser des interpolations linéaires ou quadratiques d'ordre n à chaque nouvelle acquisition d'une portion de mesure d'un signal ultrasonore de mesure reçu.

Le procédé de mesure d'une vitesse d'un fluide selon un troisième mode de réalisation utilise à nouveau un unique microcontrôleur. Le procédé de mesure est à nouveau purement numérique.

Le procédé de mesure consiste à acquérir et à numériser un premier signal ultrasonore de mesure reçu, acquis par le module de mesure après avoir parcouru le trajet de longueur définie d'amont en aval.

On réalise alors une interpolation sinusoïdale lobe par lobe permettant de suréchantillonner le signal reçu.

L'interpolation sinusoïdale utilise à nouveau des échantillons de référence contenus dans une table de référence préremplie et stockée dans une mémoire.

On obtient ainsi un nombre p de premiers échantillons de mesure $a1_i$ (i varie ici entre 1 et p). Les premiers échantillons de mesure sont espacés temporellement de 50ps.

Le procédé de mesure consiste ensuite à acquérir et à numériser un deuxième signal ultrasonore de mesure reçu, acquis par le module de mesure après avoir parcouru le trajet de longueur définie d'aval en amont.

On obtient ainsi, après interpolation sinusoïdale, un nombre p de deuxièmes échantillons de mesure $a2_i$ (i varie ici entre 1 et p). Les deuxièmes échantillons de mesure sont espacés temporellement de 50ps.

On calcule ensuite, pour différentes valeurs de m positives, négatives et nulle, la fonction de corrélation croisée $K_m$ :

$$K_m = \sum_{i=0}^{i=p} a1_i a2_{i+m}.$$

Les premiers échantillons $a1_i$ sont donc retardés dans le cas où m>0 (et avancés dans le cas où m<0), dans cette formule, de mx50ps par rapport aux deuxièmes échantillons $a2_{i+m}$.

Lorsque la fonction de corrélation croisée Km est maximale, le premier signal ultrasonore de mesure reçu, qui est retardé de mx50ps, et le deuxième signal ultrasonore de mesure reçu, sont en phase.

La valeur de m qui maximise la fonction de corrélation croisée donne donc un décalage temporel entre le premier signal ultrasonore de mesure reçu et le deuxième signal ultrasonore de mesure reçu. Le décalage temporel correspond au DToF, grâce auquel la vitesse moyenne du fluide est estimée.

Bien entendu, l'invention n'est pas limitée aux modes de réalisation décrits mais englobe toute variante entrant dans le champ de l'invention telle que définie par les revendications.

Bien que l'on ait présenté une certaine architecture matérielle du module de mesure, celle-ci pourrait être différente. Les composants électriques du module de mesure peuvent aussi être différents. Le convertisseur analogique numérique pourrait par exemple être un convertisseur différent, par exemple un convertisseur Sigma Delta 16 bits. De même, au lieu de comprendre deux inverseurs montés en série, chaque étage de retard pourrait comporter une bascule D asynchrone.

L'invention s'applique bien sûr quels que soient le positionnement et la configuration du premier transducteur et du deuxième transducteur. Les signaux ultrasonores de mesure peuvent être émis avec une orientation d'un angle quelconque par rapport à un axe longitudinal du conduit. Les signaux ultrasonores de mesure peuvent être réfléchis par des réflecteurs, par exemple par des miroirs orientés à 45°.

## Revendications

1. Procédé de mesure d'une vitesse d'un fluide, comprenant les étapes de :

   - émettre un signal ultrasonore de mesure (Se) ;
   - acquérir et numériser une portion de mesure (25, 26) d'un signal ultrasonore de mesure reçu (Sr, Sr1, Sr2) après que le signal ultrasonore de mesure (Se) ait parcouru un trajet de longueur définie (L), pour obtenir des échantillons de mesure ;
   - estimer, à partir des échantillons de mesure, une amplitude de la portion de mesure ;
   - accéder à des échantillons de référence d'une table de référence préremplie et stockée dans une mémoire, les échantillons de référence formant une courbe de référence qui constitue une interpolation des échantillons de mesure ;
   - produire des échantillons de mesure ajustés en multipliant les échantillons de mesure par un rapport entre une amplitude de la courbe de référence (30, 43) et l'amplitude de la portion de mesure ;
   - pour chaque échantillon de mesure ajusté, déterminer un décalage temporel unitaire entre l'échantillon de mesure ajusté et la courbe de référence ;
   - pour chaque échantillon de mesure ajusté, estimer un instant de passage par zéro de la portion de mesure à partir du décalage temporel unitaire et des échantillons de référence ;
   - estimer, à partir d'une moyenne des instants de passage par zéro, une mesure de temps de trajet du signal ultrasonore de mesure pour parcourir le trajet de longueur définie ;
   - estimer la vitesse du fluide à partir de la mesure de temps de trajet.

2. Procédé de mesure selon la revendication 1, dans lequel le décalage temporel unitaire est déterminé en réalisant une interpolation linéaire ou une interpolation quadratique d'ordre n à partir des échantillons de référence.

3. Procédé de mesure selon la revendication 1, comprenant en outre les étapes de mesurer une température du fluide et de sélectionner, en fonction de la température du fluide, la courbe de référence parmi une pluralité de courbes de référence mémorisées.

4. Procédé de mesure selon la revendication 1, comprenant en outre une étape préliminaire consistant à estimer et à soustraire aux échantillons de mesure un *offset* desdits échantillons de mesure.

5. Procédé de mesure selon la revendication 1, comprenant en outre l'étape d'appliquer à un échantillonnage de la portion de mesure un retard d'échantillonnage égal à une moyenne des décalages temporels unitaires.

6. Procédé de mesure selon la revendication 5, dans lequel l'application du retard d'échantillonnage consiste à retarder un signal d'horloge (CLK) qui cadence un convertisseur analogique numérique (21) qui numérise la portion de mesure.

7. Procédé de mesure selon la revendication 6, comprenant les étapes, pour retarder le signal d'horloge, de :

   - appliquer le signal d'horloge en entrée d'une chaîne (35) formée d'une pluralité d'étages de retard, la sortie de chaque étage de retard étant associée à un retard déterminé ;
   - sélectionner la sortie de l'étage de retard dont le retard déterminé correspond au retard d'échantillonnage.

8. Procédé de mesure selon la revendication 7, dans lequel un multiplexeur (36) ainsi que la chaîne (35) formée de la pluralité d'étages de retard sont programmés dans un FPGA (17), le multiplexeur (36) étant utilisé pour réaliser la sélection de la sortie de l'étage de retard.

9. Procédé de mesure selon la revendication 1, comprenant en outre les étapes de :

   - réaliser une pluralité de mesures de temps de trajet ;
   - calculer la moyenne M' des mesures de temps de trajet ;
   - éliminer des mesures de temps de trajet imprécises (40) situées à l'extérieur d'une plage [M'-X ; M'+X] ;
   - calculer une moyenne M des mesures de temps de trajet (41) à l'intérieur de la plage [M'-X ; M'+X] ;
   - estimer la vitesse du fluide à partir de la moyenne M.

10. Procédé de mesure selon la revendication 1, comprenant les étapes de :

    - émettre un premier signal ultrasonore de mesure et un deuxième signal ultrasonore de mesure ;
    - acquérir et numériser une première portion de mesure d'un premier signal ultrasonore de mesure reçu après que le premier signal ultrasonore de mesure ait parcouru un trajet de longueur définie d'amont en aval, pour obtenir des premiers échantillons de mesure ;
    - acquérir et numériser une deuxième portion de mesure d'un deuxième signal ultrasonore de mesure reçu après que le deuxième signal ultrasonore de mesure ait parcouru le trajet de longueur définie d'aval en amont, pour obtenir des deuxièmes échantillons de mesure ;
- maximiser une fonction de corrélation croisée entre les premiers échantillons de mesure et les deuxièmes échantillons de mesure pour obtenir une différence de temps de trajet ;
- estimer la vitesse du fluide à partir de la différence de temps de trajet.

**11.** Compteur de fluide à ultrason comportant un premier transducteur (12a), un deuxième transducteur (12b), et un module de mesure (13) comportant un microcontrôleur maître (15), un microcontrôleur esclave (16) et un FPGA (17) dans lequel est programmé un bloc de génération de retard (33), le compteur de fluide à ultrason étant agencé pour mettre en œuvre le procédé de mesure selon l'une des revendications précédentes.

**12.** Compteur de fluide à ultrason selon la revendication 11, dans lequel le bloc de génération de retard comporte un multiplexeur (36) et une chaîne (35) formée d'une pluralité d'étages de retard, la sortie de chaque étage de retard étant associée à un retard déterminé et étant reliée à une entrée du multiplexeur.

**13.** Compteur de fluide à ultrason selon la revendication 12, dans lequel le microcontrôleur esclave comprend un convertisseur analogique numérique qui numérise la portion de mesure, dans lequel un signal d'horloge est appliqué en entrée de la chaîne, dans lequel le microcontrôleur maître pilote le multiplexeur, et dans lequel un signal d'horloge décalé (CLK') se trouve en sortie du multiplexeur et est utilisé pour cadencer le convertisseur analogique numérique.

**14.** Programme d'ordinateur comprenant des instructions pour mettre en œuvre, par un microcontrôleur d'un compteur de fluide à ultrason, le procédé de mesure selon l'une des revendications 1 à 10.

**15.** Moyens de stockage, **caractérisés en ce qu'**ils stockent un programme d'ordinateur comprenant des instructions pour mettre en œuvre, par un microcontrôleur d'un compteur de fluide à ultrason, le procédé de mesure selon l'une des revendications 1 à 10.

**Patentansprüche**

**1.** Messverfahren zum Messen einer Geschwindigkeit eines Fluids, umfassend die Schritte:

- Senden eines Ultraschallmesssignals (Se);
- Erfassen und Digitalisieren eines Messabschnitts (25, 26) eines empfangenen Ultraschallmesssignals (Sr, Sr1, Sr2), nachdem das Ultraschallmesssignal (Se) eine Strecke definierter Länge (L) zurückgelegt hat, um Messproben zu erhalten;
- Schätzen einer Amplitude des Messabschnitts anhand der Messproben;
- Zugreifen auf Referenzproben einer vorgefüllten und in einem Speicher gespeicherten Referenztabelle, wobei die Referenzproben eine Referenzkurve bilden, die eine Interpolation der Messproben darstellt;
- Erzeugen von angepassten Messproben, indem die Messproben mit einem Verhältnis zwischen einer Amplitude der Referenzkurve (30, 43) und der Amplitude des Messabschnitts multipliziert wird;
- für jede angepasste Messprobe, Bestimmen einer unitären zeitlichen Verschiebung zwischen der angepassten Messprobe und der Referenzkurve;
- für jede angepasste Messprobe, Schätzen einer Null-Durchgangszeit des Messabschnitts anhand der unitären zeitlichen Verschiebung und der Referenzproben;
- Schätzen anhand eines Mittelwertes der Null-Durchgangszeiten einer Streckenzeitmessung des Ultraschallmesssignals zum Zurücklegen der Strecke definierter Länge;
- Schätzen der Geschwindigkeit des Fluids anhand der Streckenzeitmessung.

**2.** Messverfahren nach Anspruch 1, bei dem die unitäre zeitliche Verschiebung bestimmt wird, indem eine lineare Interpolation oder eine quadratische Interpolation der Ordnung n auf der Basis der Referenzproben durchgeführt wird.

**3.** Messverfahren nach Anspruch 1, ferner umfassend die Schritte des Messens einer Temperatur des Fluids und des Auswählens in Abhängigkeit von der Temperatur des Fluids der Referenzkurve unter einer Vielzahl von gespeicherten Referenzkurven.

**4.** Messverfahren nach Anspruch 1 ferner umfassend einen vorbereitenden Schritt bestehend aus dem Schätzen und dem Abziehen von den Messproben eines Offsets der genannten Messproben.

**5.** Messverfahren nach Anspruch 1, ferner umfassend den Schritt des Anwendens an einer Abtastung des Messabschnitts einer Abtastverzögerung gleich einem Mittelwert der unitären zeitlichen Verschiebungen.

**6.** Messverfahren nach Anspruch 5, bei dem die Anwendung der Abtastverzögerung darin besteht, ein Taktsignal (CLK) zu verzögern, das einen Analog-Digital-Umwandler (21) taktet, der den Messabschnitt digitalisiert.

**7.** Messverfahren nach Anspruch 6, umfassend zum Verzögern des Taktsignals die Schritte:

- Anlegen des Taktsignals am Eingang einer Kette (35), die aus einer Vielzahl von Verzögerungsstufen gebildet ist, wobei der Ausgang jeder Verzögerungsstufe mit einer vorbestimmten Verzögerung verknüpft ist;
- Auswählen des Ausgangs der Verzögerungsstufe, deren bestimmte Verzögerungsstufe der Abtastverzögerung entspricht.

**8.** Messverfahren nach Anspruch 7, bei dem ein Multiplexer (36) sowie die Kette (35), die aus der Vielzahl von Verzögerungsstufen gebildet ist, in einem FPGA (17) programmiert sind, wobei der Multiplexer (36) verwendet wird, um die Auswahl des Ausgangs der Verzögerungsstufe durchzuführen.

**9.** Messverfahren nach Anspruch 1, ferner umfassend die Schritte:

- Durchführen einer Vielzahl von Streckenzeitmessungen;
- Berechnen eines Mittelwerts M' der Streckenzeitmessungen;
- Entfernen ungenauer Streckenzeitmessungen (40), die sich außerhalb eines Bereichs [M'-X; M'+X] befinden;
- Berechnen eines Mittelwerts M der Streckenzeitmessungen (41) innerhalb des Bereichs [M'-X; M'+X];
- Schätzen der Geschwindigkeit des Fluids anhand des Mittelwerts M.

**10.** Messverfahren nach Anspruch 1, umfassend die Schritte:

- Senden eines ersten Ultraschallmesssignals und eines zweiten Ultraschallmesssignals;
- Erfassen und Digitalisieren eines ersten Messabschnitts eines empfangenen ersten Ultraschallmesssignals, nachdem das erste Ultraschallmesssignal eine Strecke definierter Länge von stromaufwärts nach stromabwärts zurückgelegt hat, um erste Messproben zu erhalten;
- Erfassen und Digitalisieren eines zweiten Messabschnitts eines empfangenen zweiten Ultraschallmesssignals, nachdem das zweite Ultraschallmesssignal die Strecke definierter Länge von stromabwärts nach stromaufwärts zurückgelegt hat, um zweite Messproben zu erhalten;
- Maximieren einer Kreuzkorrelationsfunktion zwischen den ersten Messproben und den zweiten Messproben, um eine Streckenzeitdifferenz zu erhalten;
- Schätzen der Geschwindigkeit des Fluids anhand der Streckenzeitdifferenz.

**11.** Ultraschall-Fluidzähler, umfassend einen ersten Wandler (12a), einen zweiten Wandler (12b) und ein Messmodul (13), das ein Master-Mikrosteuergerät (15), ein Slave-Mikrosteuergerät (16) und ein FPGA (17) umfasst, in dem ein Verzögerungserzeugungsblock (33) programmiert ist, wobei der Ultraschall-Fluidzähler ausgebildet ist, um das Messverfahren nach einem der vorhergehenden Ansprüche durchzuführen.

**12.** Ultraschall-Fluidzähler nach Anspruch 11, bei dem der Verzögerungserzeugungsblock einen Multiplexer (36) und eine Kette (35) umfasst, die aus einer Vielzahl von Verzögerungsstufen gebildet ist, wobei der Ausgang jeder Verzögerungsstufe mit einer bestimmten Verzögerung verknüpft und mit einem Eingang des Multiplexers verbunden ist.

**13.** Ultraschall-Fluidzähler nach Anspruch 12, bei dem das Slave-Mikrosteuergerät einen Analog-Digital-Wandler umfasst, der den Messabschnitt digitalisiert, wobei ein Taktsignal am Eingang der Kette angelegt wird, wobei das Master-Mikrosteuergerät den Multiplexer steuert und wobei sich ein versetztes Taktsignal (CLK') am Ausgang des Multiplexers befindet und zum Takten des Analog-Digital-Wandlers verwendet wird.

**14.** Computerprogramm, umfassend Anweisungen zum Durchführen des Messverfahrens nach einem der Ansprüche 1 bis 10 mittels eines Mikrosteuergerätes eines Ultraschall-Fluidzählers.

**15.** Speichermittel, die **dadurch gekennzeichnet sind, dass** sie ein Computerprogramm speichern, das Anweisungen zum Durchführen des Messverfahrens nach einem der Ansprüche 1 bis 10 mittels eines Mikrosteuergeräts eines Ultraschall-Fluidzählers umfasst.

**Claims**

**1.** A method for measuring a speed of a fluid, comprising the steps of:

- emitting a measurement ultrasound signal (Se);
- acquiring and digitizing a measurement portion (25, 26) of a measurement ultrasound signal (Sr, Sr1, Sr2) received after the measurement ultrasound signal (Se) has traversed a path of defined length (L), to obtain measurement samples;

- estimating, on the basis of the measurement samples, an amplitude of the measurement portion;

- accessing reference samples of a prefilled reference table stored in a memory, the reference samples forming a reference curve which constitutes an interpolation of the measurement samples;

- producing adjusted measurement samples by multiplying the measurement samples by a ratio between an amplitude of the reference curve (30, 43) and the amplitude of the measurement portion;

- determining, for each adjusted measurement sample, a unit time shift between the adjusted measurement sample and the reference curve;

- estimating, for each adjusted measurement sample, an instant of zero crossing of the measurement portion on the basis of the unit time shift and of the reference samples;

- estimating, on the basis of an average of the instants of zero crossing, a measurement of path time of the measurement ultrasound signal to traverse the path of defined length;

- estimating the speed of the fluid on the basis of the path time measurement.

2. The measurement method according to Claim 1, in which the unit time shift is determined by carrying out a linear interpolation or a quadratic interpolation of order n on the basis of the reference samples.

3. The measurement method according to Claim 1, further comprising the steps of measuring a temperature of the fluid and of selecting, as a function of the temperature of the fluid, the reference curve from among a plurality of stored reference curves.

4. The measurement method according to Claim 1, further comprising a preliminary step consisting in estimating and in subtracting from the measurement samples an offset of the said measurement samples.

5. The measurement method according to Claim 1, further comprising the step of applying to a sampling of the measurement portion a sampling delay equal to an average of the unit time shifts.

6. The measurement method according to Claim 5, in which the application of the sampling delay consists in delaying a clock signal (CLK) which regulates an analogue-digital converter (21) which digitizes the measurement portion.

7. The measurement method according to Claim 6, comprising the steps, to delay the clock signal, of:

- applying the clock signal at input to a chain (35) formed of a plurality of delay stages, the output of each delay stage being associated with a determined delay;

- selecting the output of the delay stage whose determined delay corresponds to the sampling delay.

8. The measurement method according to Claim 7, in which a multiplexer (36) as well as the chain (35) formed of the plurality of delay stages are programmed in an FPGA (17), the multiplexer (36) being used to carry out the selection of the output of the delay stage.

9. The measurement method according to Claim 1, further comprising the steps of:

- carrying out a plurality of path time measurements;

- calculating the average M' of the path time measurements;

- eliminating inaccurate path time measurements (40) situated outside a span [M'-X; M'+X];

- calculating an average M of the path time measurements inside the span [M'-X; M'+X];

- estimating the speed of the fluid on the basis of the average M.

10. The measurement method according to Claim 1, comprising the steps of:

- emitting a first measurement ultrasound signal and a second measurement ultrasound signal;

- acquiring and digitizing a first measurement portion of a first measurement ultrasound signal received after the first measurement ultrasound signal has traversed a path of defined length from upstream to downstream, to obtain first measurement samples;

- acquiring and digitizing a second measurement portion of a second measurement ultrasound signal received after the second measurement ultrasound signal has traversed the path of defined length from downstream to upstream, to obtain second measurement samples;

- maximizing a cross-correlation function between the first measurement samples and the second measurement samples to obtain a path time difference;

- estimating the speed of the fluid on the basis of the path time difference.

11. An ultrasound-based fluid meter comprising a first transducer (12a), a second transducer (12b), and a measurement module (13) comprising a master microcontroller (15), a slave microcontroller (16) and an FPGA (17) in which is programmed a delay generation block (33), the ultrasound-based fluid meter being designed to implement the measurement method according to one of the preceding claims.

12. The ultrasound-based fluid meter according to Claim 11, in which the delay generation block comprises a multiplexer (36) and a chain (35) formed of a plurality of delay stages, the output of each delay stage being associated with a determined delay and being linked to an input of the multiplexer.

13. The ultrasound-based fluid meter according to Claim 12, in which the slave microcontroller comprises an analogue-digital converter which digitizes the measurement portion, in which a clock signal is applied as input to the chain, in which the master microcontroller drives the multiplexer, and in which a shifted clock signal (CLK') is situated at the output of the multiplexer and is used to regulate the analogue-digital converter.

14. A computer program comprising instructions for implementing, by a microcontroller of an ultrasound-based fluid meter, the measurement method according to any one of Claims 1 to 10.

15. Storage means, **characterized in that** they store a computer program comprising instructions for implementing, by a microcontroller of an ultrasound-based fluid meter, the measurement method according to any one of Claims 1 to 10.

Fig. 1

**Fig. 2**

EP 3 645 981 B1

Fig. 3

EN

N

k+1

k

E1  E2

1

-36-

35

33

17

13

38

CLK

1
1
0
1

-32-

Sr

-21-
-16-

-20-
-15-

-18-

S

CLK'

RESET

22

Fig. 4

**Fig. 5**

Fig. 6

**EP 3 645 981 B1**

## RÉFÉRENCES CITÉES DANS LA DESCRIPTION

### Documents brevets cités dans la description

- US 2016334255 A1